Europäisches Patentamt

European Patent Office

Office européen des brevets

(11) Veröffentlichungsnummer: **0 250 926 B1**

(12) **EUROPÄISCHE PATENTSCHRIFT**

(45) Veröffentlichungstag der Patentschrift: **12.01.94**

(21) Anmeldenummer: **87108153.5**

(22) Anmeldetag: **05.06.87**

(51) Int. Cl.⁵: **H03H 17/06**

(54) **Nichtrekursives Halb-Band-Filter.**

(30) Priorität: **28.06.86 DE 3621737**

(43) Veröffentlichungstag der Anmeldung:
**07.01.88 Patentblatt 88/01**

(45) Bekanntmachung des Hinweises auf die
Patenterteilung:
**12.01.94 Patentblatt 94/02**

(84) Benannte Vertragsstaaten:
**FR GB IT SE**

(56) Entgegenhaltungen:
**EP-A- 0 279 208**
**WO-A-88/06380**

**IEEE INTERNATIONAL CONFERENCE ON
ACOUSTICS, SPEECH AND SIGNAL PROCES-
SING, Boston, Massachusetts, 14.-16. April
1983, Band 1, Seiten 221-223, IEEE, New York,
US; H.J. NUSSBAUMER: "Complex quadrature mirror filters"**

**IEEE TRANSACTIONS ON COMMUNICA-
TIONS-TEIL II, Band COM-28, Nr. 9, September 1980, Seiten 1709-1716, IEEE, New York,
US; T. AOYAMA et al.: "120-Channel transmultiplexer design and performance"**

**IEEE TRANSACTIONS ON COMMUNICA-
TIONS, Band COM-30, Nr. 7, Juli 1982, Teil 1,
Seiten 1629-1641, IEEE, New York, US; A.G.
CONSTANTINIDES et al.: "An efficient and
modular transmultiplexer design"**

(73) Patentinhaber: **ANT Nachrichtentechnik GmbH
Gerberstrasse 33
D-71522 Backnang(DE)**

(72) Erfinder: **Göckler, Heinz, Dipl.-Ing.
Elbinger Strasse 52
D-7150 Backnang(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein nichtrekursives Halb-Band-Filter. Solche Filter sind bekannt geworden durch den Aufsatz "Interpolation, Extrapolation, and Reduction of Computation Speed in Digital Filters" von Bellanger et al in IEEE Transactions on Acoustics, Speech and Signal Processing, Vol. ASSP-22, Nr. 4, Aug. 74, S. 231 ff.

Die bekannten Halb-Band-Filter verarbeiten reelle Eingangssignale zu reellen Ausgangssignalen.

Der vorliegenden Erfindung lag die folgende Aufgabe zugrunde, ein nicht rekursives Halb-Band-Filter anzugeben, welches die Umwandlung eines reellen Eingangssignals in ein komplexes Ausgangssignal oder umgekehrt in wenig aufwendiger Weise ermöglicht.

Die Lösung erfolgt mit den Merkmalen des Anspruches 1 bzw. 2.

Das erfindungsgemäße nichtrekursive Halb-Band-Filter gestattet die Umwandlung reeller digitaler Eingangssignale in komplexe digitale Ausgangssignale bei gleichzeitiger Verminderung der Abtastfrequenz um den Faktor 2 bzw. die Umwandlung komplexer digitaler Eingangssignale in reelle digitale Ausgangssignale bei gleichzeitiger Erhöhung der Abtastfrequenz um den Faktor 2. Dieses relativ unaufwendige Halb-Band-Filter eignet sich damit als digitales Vorfilter oder Nachfilter für digitale Systeme zur Verarbeitung komplexer Signale und als digitale Teilfilter einer Anordnung von Antialiasing Filtern zur Bandbegrenzung unter Erfüllung des Abtasttheorems. Der Vorteil des Halb-Band-Filters liegt in der linearen Phase und in dem gleich- zeitig geringen Aufwand, wobei jeweils die aufgrund des Abtasttheorems erforderliche minimal mögliche Abtastfrequenz verwendet werden kann.

Es folgt nun die Beschreibung anhand der Figuren.

Die Figur 1 zeigt das Blockschaltbild des erfindungsgemäßen Digitalfilters.

In Figur 2a bis 2c sind einige Amplitudenantworten von Halb-Band-Filtern über der Frequenz aufgetragen.

Die Figuren 3 und 4 zeigen besonders günstige Schaltungsvarianten des Halb-Band-Filters.

In Figur 5 schließlich ist das Blockschaltbild eines Halb-Band-Filters zu Verarbeitung eines komplexen Eingangssignals in ein reelles Ausgangssignal gezeichnet.

Die Figur 6 zeigt die detaillierte Schaltung des Filters nach Fig. 5, wobei diese Schaltung aus der Figur 3 durch Transposition entwickelt wurde, d.h. durch Umkehrung aller Pfeilrichtungen und den Ersatz einer Verzweigung durch einen Addierer und umgekehrt und den Ersatz eines Demultiplexers durch einen Multiplexer.

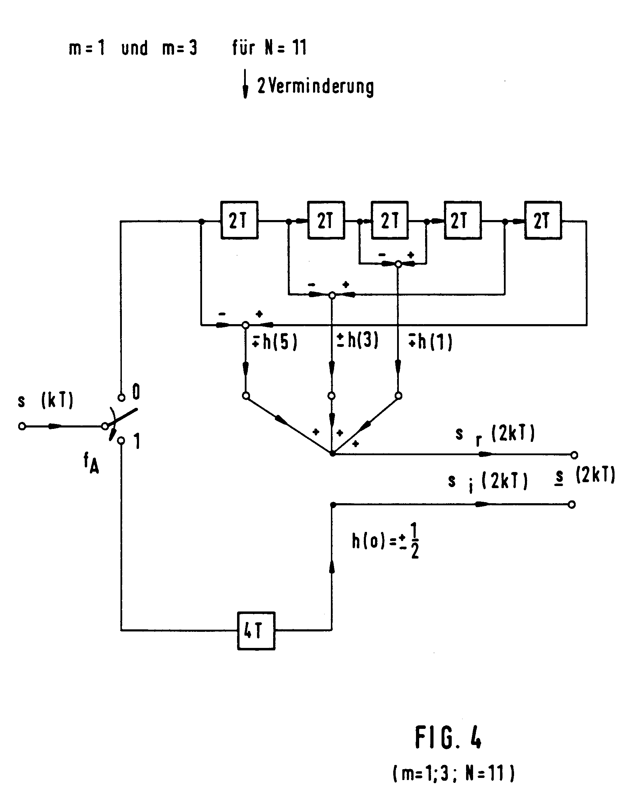

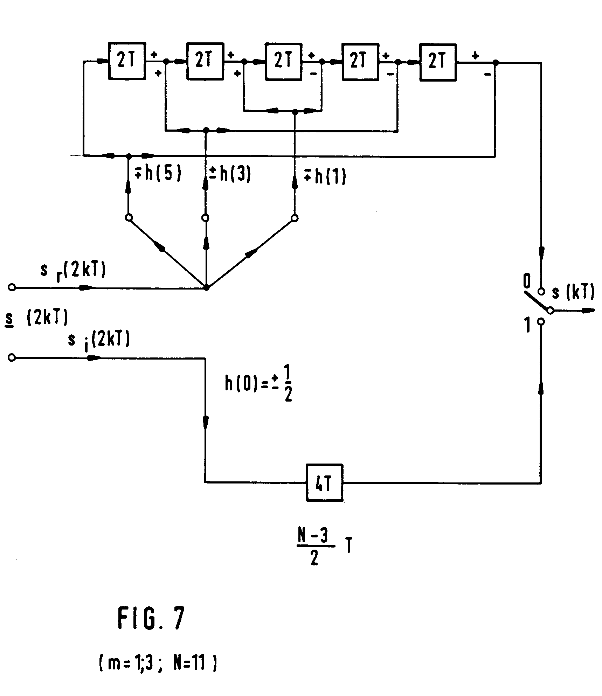

In entsprechender Weise ist die Schaltung nach Figur 7 aus der der Figur 4 entstanden.

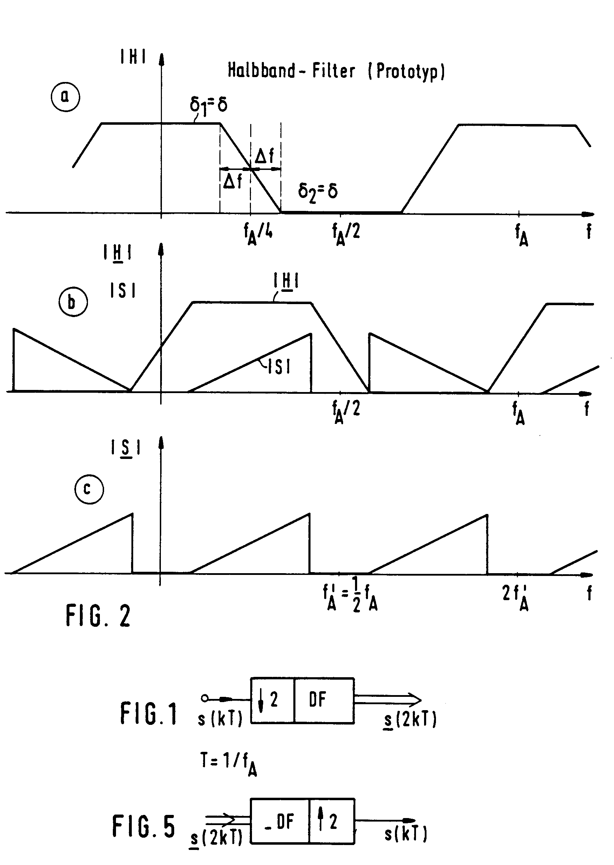

In Figur 1 wird das reelle Eingangssignal s(kT) durch Halbierung der Abtastrate dem digitalen Halb-Band-Filter DF zugeführt, welches daraus das komplexe Ausgangssignal $\underline{s}$(2kT) erzeugt.

In Figur 2a ist die Amplitudenfrequenzantwort eines Prototyp-Halb-Band-Filters erkennbar, sein Durchlaßbereich reicht von -fA/4 +Δf bis +fA/4 -Δf, und sein Sperrbereich ist ebenfalls fA/2 -2Δf breit. Kennzeichnend für das Halb-Band-Filter ist weiterhin, daß der Übergang vom Sperrzum Durchlaßbereich stetig ist und auf einer Breite von 2Δf erfolgt. Dieser Übergangsbereich ist symmetrisch zu fA/4. Ein weiteres Kennzeichen des Halb-Band-Filters ist, daß sein Ripple im Durchlaß- und Sperrbereich gleich ist nämlich δ1 = δ2 = δ. Bei einem solchen Filter ergibt sich eine Impulsanwort h(1) mit 1 = 0 bis N-1 und der ungeraden Filterlänge N, und es ergibt sich, daß jeder 2. Wert identisch Null ist, ausgenommen der mittlere Hauptwert (s. hierzu auch Fig. 2 auf S. 233 in dem o.g. Aufsatz von Bellanger et al). Die Figur 2b zeigt den Frequenzgang |$\underline{H}$|. Man sieht, daß dieser Frequenzgang um die Frequenz fA/4 gegenüber dem Frequenzgang des Prototyp-Halb-Band-Filters nach rechts verschoben ist. In die Figur 2b ist zusätzlich das Spektrum |S| eines reellen mit der Abtastfrequenz fA abgetasteten Eingangssignals s(kT) eingezeichnet, das sich aufgrund der Abtastung mit fA in den Frequenzbereichen [m•fA, (m + 1/2)•fA] in Regellage und in den Frequenzbereichen [(m + 1/2)•fA, (m + 1)•fA] in Kehrlage mit m = ...-1, 0, +1... periodisch wiederholt. Das Eingangssignal s(kT), angewandt auf das erfindungsgemäße Halb-Band-Filter ohne Abtastratenänderung, würde also die Kehrlage zwischen fA/2 und fA und natürlich mit sämtlichen Wiederholungen unterdrücken und gleichzeitig ein komplexes Signal $\underline{s}$(kT) erzeugen. Eine Abtastratenhalbierung bringt nun die gewünschten Spektren, wobei die Normallage jeweils im Raster von fA/2 = fA', also der neuen Abtastrate wiederholt wird, s. Fig. 2c.

An dieser Stelle sei erwähnt, daß man am Ausgang des Halb-Band-Filters ein komplexes Signal in Kehrlage erhält, wenn der Frequenzgang des Prototyp-Halb-Band-Filters gemäß Figur 2a um -fA/4 oder, was gleichbedeutend ist, um +3fA/4 verschoben wird.

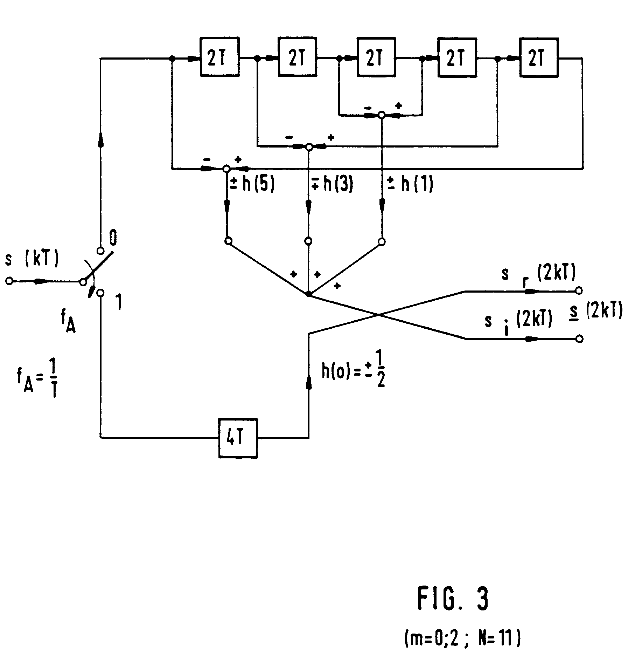

Die Figur 3 zeigt nun ein detaillierteres Ausführungsbeispiel eines erfindungsgemäßen Halb-Band-Filters. Zunächst sei jedoch noch etwas zu Fig. 2 gesagt, wonach ja die Abtastratenhalbierung erst nach der Filterung angesprochen wurde. Diese Reihenfolge des Vorgehens nach Fig. 2 wäre formal zu befolgen, jedoch kann gemäß der Erfindung das Halb-Band-Filter in 2 Zweige aufgeteilt werden, welche von vornherein schon jeweils mit jedem 2. Abtastwert des Eingangssignals versorgt werden. Diese bedeutet aber nichts anderes, als daß, wie auch im Blockschaltbild der Fig. 1 angegeben, die Abtastratenhalbierung direkt am Filtereingang erfolgen kann. Entsprechend enthalten die detaillierteren Schaltungsausführungen der Figuren 3 und 4 einen eingangsseitigen Demultipliexer-Schalter, welcher mit dem Eingangssignal s(kT) einmal den oberen Zweig und zum anderen den unteren Zweig jeweils im Takte der Abtastrate fA' = fA/2 versorgt.

Sowohl Figur 3 als auch Figur 4 stellt beispielhaft eine Realisierung dar für eine Filterlänge N = 11. Dementsprechend enthält der untere Zweig ein Verzögerungsglied der Verzögerungszeit (N-3)•T/2 = 4T, während der obere Zweig eine Kette von 5 Verzögerungsgliedern der Verzögerungszeit 2T enthält. In Figur 3 sind nun 2 Realisierungen dargestellt, nämlich für einen Modulationsphasenwinkel $\phi 0 = 0$ und $\phi 0 = \pi$ entsprechend m = 0 und m = 2.

Das Ausgangssignal des Verzögerungsgliedes des unteren Zweiges wird mit h(5) = 1/2 bewertet (multipliziert) und ergibt damit den Imaginärteil si(2kT) des Ausgangssignals. Bei m = 2 wird mit -1/2 bewertet. Die weitere Verarbeitung des oberen Zweiges erfolgt nun derart, daß (N + 1)/4 = 3 Differenzsignale gebildet werden:

1. Differenzsignal = Eingangssignal des 1. minus Ausgangssignal des letzten Verzögerungsgliedes,
2. Differenzsignal = Eingangssignal des 2. minus Ausgangssignal des zweitletzten Verzögerungsgliedes und
3. Differenzsignal = Eingangssignal des 3. minus Ausgangssignal des drittletzten also des mittleren Verzögerungsgliedes.

Anschließend werden diese Differenzsignale bewertet (multipliziert), summiert und ergeben somit den Realteil des Ausgangssignals s(2kT). Die Bewertung erfolgt nach den folgenden Tabellen.

Beispiele für N = 11 und h(-1) = h(1) für 1 = 0, 1,...5, entsprechend dem Prototyp-Halb-Band-Filter gemäß Frequenzgang Figur 2a:

Tabelle 1:

m = 0 (m = 2 mit jeweils anderem Vorzeichen der komplexen Koeffizienten h = Re(h)+jJm(h))

| 1 | -5 | -3 | -1 | 0 | 1 | 3 | 5 |
|---|---|---|---|---|---|---|---|
| Re(h) | 0 | 0 | 0 | h(0) | 0 | 0 | 0 |
| Jm(h) | -h(5) | h(3) | -h(1) | 0 | h(1) | -h(3) | h(5) |

Tabelle 2:

m = 1 (m = 3 mit jeweils anderen Vorzeichen der komplexen Koeffizienten)

| 1 | -5 | -3 | -1 | 0 | 1 | 3 | 5 |
|---|---|---|---|---|---|---|---|
| Re(h) | h(5) | -h(3) | h(1) | 0 | -h(1) | h(3) | -h(5) |
| Jm(h) | 0 | 0 | 0 | h(0) | 0 | 0 | 0 |

Die Realisierung gemäß Fig. 4 erfolgt in der gleichen Weise wie die nach der Figur 3, der Unterschied liegt allein im anderen Nullphasenwert $\phi 0 = m \cdot \pi/2$ mit m = 1 und 3, was lediglich eine andere Bewertung und einen Tausch der Filterzweigausgänge zur Folge hat.

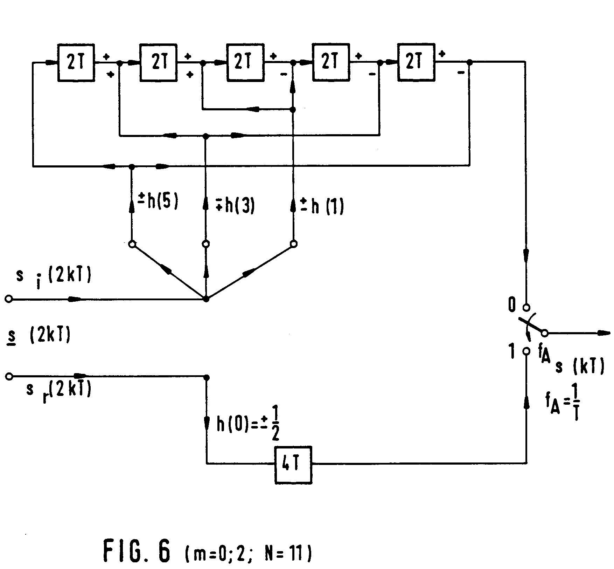

Die Figur 5 zeigt das Blockschaltbild für den umgekehrten Einsatz des Halb-Band-Filters nach Figur 1, nämlich zur Erzeugung eines reellen Ausgangssignals aus einem komplexen Eingangssignal. Hierzu hat

3

eine Transposition der bisher vorgestellten Schaltungen zu erfolgen, was eine Umkehrung aller Pfeilrichtungen und ein Ersatz einer Verzweigung durch einen Addierer und umgekehrt sowie den Ersatz eines Demultiplexers durch einen Multiplexer zur Folge hat. In entsprechender Weise gehen das Schaltungsausführungsbeispiel der Figur 6 aus der Figur 3 und die Schaltung nach Figur 7 aus Figur 4 hervor.

**Patentansprüche**

1. Nichtrekursives Halb-Band-Filter mit komplexen Koeffizienten zur Verarbeitung eines reellwertigen Eingangssignals s(kT) unter Halbierung der Abtastfrequenz fA = 1/T und zur Umwandlung dieses reellwertigen Eingangssignals s(kT) in ein komplexwertiges Ausgangssignal $\underline{s}$(2kT), dadurch gekennzeichnet,
   daß seine komplexen Koeffizienten $\underline{h}$(l) mit l = -(N-1)/2 bis (N-1)/2 und der ungeraden Filterlänge N, abwechselnd rein reelle und rein imaginäre Werte, also keine im üblichen Sinne komplexen Werte aufweisen, daß die Impulsantwort eines Halb-Band-Filters h(l) mit ausschließlich reellen Werten, mit den Eigenschaften h(l) = h(-l) für alle $\|l\| \leq$ (N-1)/2 und h(l) = 0 für l = ±2, ±4, ..., auf den komplexen Träger einer Frequenz von ±1/4 der Eingangs-Abtastfrequenz fA = 1/T moduliert wird zu

   $$\underline{h}(l) = h(l) \cdot e^{j(\pm 2\pi l fA/4fA) + \phi 0)} = j^{\pm l} \cdot e^{j\phi 0} \cdot h(l)$$

   und daß die Nullphase $\phi 0$ dieses komplexen Trägers ganze Vielfache m von $\pi/2$ beträgt ($\phi 0 = m \cdot \pi/2$ mit m = 0, 1, 2, 3, ...).

2. Nichtrekursives Halb-Band-Filter, mit komplexen Koeffizienten zur Verarbeitung eines komplexwertigen Eingangssignals $\underline{s}$(2kT) und zur Verdoppelung der Abtastfrequenz fA' = 1/2T auf fA = 2fA' und zur Umwandlung dieses komplexwertigen Eingangssignals $\underline{s}$(2kT) in ein reellwertiges Ausgangssignal s(kT), dadurch gekennzeichnet,
   daß seine komplexen Koeffizienten $\underline{h}$(l) mit l = -(N-1)/2 bis (N-1)/2 und der ungeraden Filterlänge N, abwechselnd rein reelle und rein imaginäre Werte, also keine im üblichen Sinne komplexen Werte aufweisen, daß die Impulsantwort eines Halb-Band-Filters h(l) mit ausschließlich reellen Werten, mit den Eigenschaften h(l) = h(-l) für alle $\|l\| \leq$ (N-1)/2 und h(l) = 0 für l = ±2, ±4, ..., auf den komplexen Träger einer Frequenz von ±1/4 der Ausgangs-Abtastfrequenz fA = 1/T moduliert wird zu

   $$\underline{h}(l) = h(l) \cdot e^{j(\pm 2\pi l fA/4fA) + \phi 0)} = j^{\pm l} \cdot e^{j\phi 0} \cdot h(l)$$

   und daß die Nullphase $\phi 0$ dieses komplexen Trägers ganze Vielfache m von $\pi/2$ beträgt ($\phi 0 = m \cdot \pi/2$ mit m = 0, 1, 2, 3, ...).

3. Nichtrekursives Halb-Band-Filter nach Anspruch 1, , dadurch gekennzeichnet
   daß jeder 2. Abtastwert des Eingangssignals s(kT) in eine Kette von (N-1)/2 Verzögerungsgliedern der Verzögerungszeit 2T geleitet wird, daß jeweils Differenzsignale gebildet werden aus Aus
   gangssignal des letzten Verzögerungsgliedes minus Eingangssignal des letzten Verzögerungsgliedes minus Eingangssignal des 1. Verzögerungsgliedes = 1. Differenzsignal, Ausgangssignal des zweitletzten Verzögerungsgliedes minus Eingangssignal des 2. Verzögerungsgliedes = 2. Differenzsignal, Ausgangssignal des zweitletzten Verzögerungsgliedes minus Eingangssignal des 3. Verzögerungsgliedes = 3. Differenzsignal usw.,
   daß diese Differenzsignale einer Bewertung (Multiplikation) mit einem Wert h(l) der Impulsantwort unterworfen werden und anschließend summiert werden und dann entweder den Real- oder Imaginärteil des Filterausgangssignals $\underline{s}$(2kT) ergeben,
   daß in einem 2. Zweig ein Verzögerungsglied mit der Verzögerungszeit T•(N - 3)/2 vorgesehen ist, in das jeder 2. gegenüber obigen Abtastwerten vesetzte Abtastwert des Eingangssignals geleitet wird und dessen Ausgangssignal, mit dem Wert h(0) bewertet, den Imaginär- oder Realteil des Filterausgangssignals $\underline{s}$(2kT) ergibt.

4. Nichtrekursives Halb-Band-Filter nach Anspruch 3, mit N = 11 und m = 1, dadurch gekennzeichnet,
   daß das 1. Differenzsignal mit -h(5), das 2. Differenzsignal mit h(3) und das 3. mit -h(1) bewertet werden, daß h(0) = 1/2 ist und
   daß die Summe der Differenzsignale den Realteil $s_r$(2kT) und das mit h(0) bewertete Signal den Imaginärteil $s_i$(2kT) ergeben (Fig. 4).

**5.** Nichtrekursives Halb-Band-Filter nach Anspruch 3, mit N = 11 und m = 3, <u>dadurch gekennzeichnet,</u> daß die Bewertung des 1. Differenzsignals mit h(5), des 2. mit -h(3), des 3. mit h(1) erfolgt, daß h(0) = -1/2 ist und daß die Summe der Differenzsignale den Realteil $s_r(2kT)$ und das mit h(0) bewertete Signal den Imaginärteil $s_i(2kT)$ ergeben (Fig. 4).

**6.** Nichtrekursives Halb-Band-Filter nach Anspruch 3, mit N = 11 und m = 0, <u>dadurch gekennzeichnet,</u> daß die Bewertung des 1. Differenzsignals mit h(5), des 2. mit -h(3) und des 3. mit h(1) erfolgt und daß die Summe der Differenzsignale den Imaginärteil $s_i(2kT)$ und das mit h(0) = 1/2 bewertete Signal den Realteil $s_r(2kT)$ ergeben (Fig. 3).

**7.** Nichtrekursives Halb-Band-Filter nach Anspruch 3, mit N = 11 und m = 2, <u>dadurch gekennzeichnet,</u> daß die Bewertung des 1. Differenzsignals mit -h(5), des 2. mit h(3), des 3. mit -h(1) erfolgt und daß die Summe der Differenzsignale den Imaginärteil $s_i(2kT)$ und das mit h(0) = -1/2 bewertete Signal den Realteil $s_r(2kT)$ ergeben (Fig. 3).

**8.** Nichtrekursives Halb-Band-Filter nach Anspruch 2, <u>dadurch gekennzeichnet,</u> daß eine Kette von (N-1)/2 Verzögerungsgliedern der Verzögerungszeit 2T vorgesehen ist, daß der mit einem Wert h(l) der Impulsantwort bewertete Realteil $s_r(2kT)$ dem 1. Verzögerungsglied dieser Kette zugeführt und vom Ausgangssignal des letzten Verzögerungsgliedes dieser Kette abgezogen wird, welches Differenzsignal jeden 2. Abtastwert des reellen Filterausgangssignals s(kT) liefert, daß auf das Transversalsignal dieser Verzögerungsgliederkette an den weiteren Punkten zusätzliche mit einem Wert h(l) der Impulsantwort bewertete Augenblickswerte des Realteils $s_r(2kT)$ des Filtereingangssignals addiert werden, daß ein weiteres Verzögerungsglied der Verzögerungszeit T•(N-3)/2 vorgesehen ist, in dessen Eingang der mit h(0) bewertete Imaginärteil $s_i(2kT)$ eingegeben wird und dessen Ausgang jeden zeitlich versetzten 2. Abtastwert des reellen Filterausgangssignals s(kT) liefert.

**9.** Nichtrekursives Halb-Band-Filter nach Anspruch 8, mit m = 0 und N = 11, <u>dadurch gekennzeichnet,</u> daß die Bewertung der zugeführten Augenblickswerte des Realteils $s_r(2kT)$ des Filtereingangssignals wie folgt erfolgt:
am Eingang des 1. Verzögerungsgliedes h(5),
am Eingang des 2. Verzögerungsgliedes -h(3),
am Eingang des 3. Verzögerungsgliedes h(1),
am Eingang des 4. Verzögerungsgliedes -h(1),
am Eingang des 5. Verzögerungsgliedes h(3) und
am Ausgang des 5. Verzögerungsgliedes -h(5) und
daß h(0) = 1/2 ist (Fig. 6).

**Claims**

**1.** Half-band non-recursive filter with complex co-efficients for the processing of a real value input signal s-(KT) with halving of the scanning frequency fA = 1/T and for the conversion of this real value input signal s(kT) into a complex value output signal $\underline{s}(2KT)$, characterised thereby, that its complex co-efficients $\underline{h}(l)$ with l = -(N-1)/2 to (N-1)/2 and the odd-numbered filter length N alternately display purely real and purely imaginary values, thus no complex values in the usual sense, that the pulse response of a half-band filter h(l) with exclusively real values, with the properties h(l) = h(-l) for all $\|l\| \leq$ (N-1)/2 and h(l) = 0 for l = ±2, ±4 ... is modulated onto the complex carrier of a frequency of ±1/4 of the input scanning frequency fA = 1/T into

$$\underline{h}(l) = h(l).e^{j(\pm 2\pi 1fA/4fA) + \phi 0)} = j^{\pm l} . e^{j\phi 0} . h(l)$$

and that the zero phase $\phi_0$ of this complex carrier amounts to integral multiples m of $\pi/2$ ($\phi 0 = m.\pi/2$ wherein m = 0, 1, 2, 3 ...).

**2.** Half-band non-recursive filter with complex co-efficients for the processing of a complex value input signal $\underline{s}(2KT)$ and for the doubling of the scanning frequency fA' = 1/2T to fA = 2fA' and for the conversion of this complex value input signal $\underline{s}(2KT)$ into a real value output signal s(kT), characterised thereby, that its complex coefficients $\underline{h}(l)$ with $\overline{l}$ = -(N-1)/2 to (N-1)/2 and the odd-numbered filter length N alternately display purely real and purely imaginary values, thus no complex values in the usual sense, that the pulse response of a half-band filter h(l) with exclusively real values, with the properties h(l) = h(-l) for all $|l| \leq$ (N-1)/2 and h(l) = 0 for l = ±2, ±4 ... is modulated onto the complex carrier of a frequency of ±1/4 of the output scanning frequency fA = 1/T into

$$\underline{h}(l) = h(l).e^{j(\pm 2\pi 1fA/4fA) + \phi 0)} = j^{\pm l} . e^{j\phi 0} . h(l)$$

and that the zero phase $\phi_0$ of this complex carrier amounts to integral multiples m of $\pi/2$ ($\phi 0$ = m.$\pi/2$ wherein m = 0, 1, 2, 3 ...).

3. Half-band non-recursive filter according to claim 1, characterised thereby, that each second scanning value of the input signal s(kT) is conducted into a chain of (N-1)/2 delay members of the delay time 2T, that difference signals are formed each time from the output signal of the last delay member minus the input signal of the first delay member = first delay signal, from the output signal of the penultimate delay member minus the input signal of the second delay member = second delay signal, from the output signal of the third-last delay member minus the input signal of the third delay member = third delay signal and so forth, that these difference signals are subjected to a weighting (multiplication) by a value h(l) of the pulse response and subsequently summated and then yield either the real part or the imaginary part of the filter output signals $\underline{s}$(2kT), that a delay member with the delay time T.(N-3)/2 is provided in a second branch, into which delay member every second scanning value, which is displaced relative to the above scanning values, is conducted and the output signal of which, weighted by the value h(0), yields either the real part or the imaginary part of the filter output signal $\underline{s}$(2kT).

4. Half-band non-recursive filter according to claim 3, wherein N = 11 and m = 1, characterised thereby, that the first difference signal is weighted by -h(5), the second difference signal is weighted by h(3) and the third difference signal is weighted by -h(1), that h(0) = 1/2 and that the sum of the difference signals yields the real part $s_r$(2kT) and the signal weighted by h(0) yields the imaginary part $s_i$(2KT) (Figure 4).

5. Half-band non-recursive filter according to claim 3, wherein N = 11 and m = 3, characterised thereby, that the weighting of the first difference signal takes place by h(5), that of the second by -h(3) and that of the third by h(1), that h(0) = -1/2 and that the sum of the difference signals yields the real part $s_r$-(2kT) and the signal weighted by h(0) yields the imaginary part $s_i$(2kT) (Figure 4).

6. Half-band non-recursive filter according to claim 3, wherein N = 11 and m = 0, characterised thereby, that the weighting of the first difference signal takes place by h(5), that of the second by -h(3) and that of the third by h(1) and that the sum of the difference signals yields the imaginary part $s_i$ (2kT) and the signal weighted by h(0) = 1/2 yields the real part $s_r$(2kT) (Figure 3).

7. Half-band non-recursive filter according to claim 3, wherein N = 11 and m = 2, characterised thereby, that the weighting of the first difference signal takes place by -h(5), that of the second by h(3) and that of the third by -h(1) and that the sum of the difference signals yields the imaginary part $s_i$ (2kT) and the signal weighted by h(0) = -1/2 yields the real part $s_r$(2kT) (Figure 3).

8. Half-band non-recursive filter according to claim 2, characterised thereby, that a chain of (N-1)/2 delay members of the delay time 2T is provided, that the real part $s_r$(2kT) weighted by a value h(l) of the pulse response is fed to the first delay member of this chain and deducted from the output signal of the last delay member of this chain, which difference signal supplies every second scanning value of the real filter output signal s(kT), that additional instantaneous values, which are weighted by a value h(l) of the pulse response, of the real part $s_r$(2kT) of the filter input signal are added to the transverse signal of this delay member chain at the further points and that a further delay member of the delay time T.(N - 3)/2 is provided, into the input of which the imaginary part $S_i$(2kT) weighted by h(0) is entered and the output of which supplies every second scanning value, displaced in time, of the real filter output signal s(kT).

9. Half-band non-recursive filter according to claim 8, wherein m = 0 and N = 11, characterised thereby, that the weighting of the supplied instantaneous values of the real part $s_r$(2kT) of the filter input signal takes place as following:

h(5) at the input of the first delay member,
-h(3) at the input of the second delay member,
h(1) at the input of the third delay member,
-h(1) at the input of the fourth delay member,
h(3) at the input of the fifth delay member and
-h(5) at the output of the fifth delay member and
that h(0) = 1/2 (Figure 6).

**Revendications**

1. Filtre demi-bande non récursif à coefficients complexes pour traiter un signal d'entrée de valeur réelle s(kT) avec division par deux de la fréquence d'échantillonnage fA = 1/T et pour convertir ce signal d'entrée de valeur réelle s(kT) en un signal de sortie de valeur complexe $\underline{s}$(2kT), filtre caractérisé
   par le fait que ses coefficients complexes $\underline{h}$(l) avec l = -(N-1)/2 à (N-1)/2 et avec la longueur impaire de filtre N présentent alternativement des valeurs purement réelles et des valeurs purement imaginaires, c'est-à-dire aucune valeur complexe au sens habituel, par le fait que la réponse impulsionnelle d'un filtre demi-bande h(l) ne comportant que des valeurs réelles, avec les caractéristiques h(l) = h(-l) pour tous les $|l| \leqq$ (N-1)/2 et h(l) = 0 pour l = $^{\pm}$2, $^{\pm}$4, ..., est modulée sur la porteuse complexe d'une fréquence de $^{\pm}$1/4 de la fréquence d'échantillonnage d'entrée fA = l/T pour donner:

$$\underline{h}(l) = h(l) . e^{j(\pm 2\pi l f A/4 f A) + \phi 0)} = j^{\pm l} . e^{j\phi 0} . h(l)$$

   et par le fait que la phase zéro $\phi$0 de cette porteuse complexe vaut des multiples entiers m de $\pi$/2 ($\phi$0 = m . $\pi$/2 avec m = 0, 1, 2, 3, ...).

2. Filtre demi-bande non récursif à coefficients complexes pour traiter un signal d'entrée de valeur complexe $\underline{s}$(2kT) et pour doubler la fréquence d'échantillonnage fA' = 1/2T qui devient fA = 2fA' et pour convertir ce signal d'entrée de valeur complexe $\underline{s}$(2kT) en un signal de sortie de valeur réelle s(kT), filtre caractérisé,
   par le fait que ses coefficients complexes $\underline{h}$(l) avec l = -(N-1)/2 à (N-1)/2 et avec la longueur impaire de filtre N présentent alternativement des valeurs purement réelles et des valeurs purement imaginaires, c'est-à-dire aucune valeur complexe au sens habituel, par le fait que la réponse impulsionnelle d'un filtre demi-bande h(l) ne comportant que des valeurs réelles, avec les caractéristiques h(l) = h(-l) pour tous les $|l| \leq$ (N-1)/2 et h(l) = 0 pour l = $^{\pm}$2, $^{\pm}$4, ..., est modulée sur la porteuse complexe d'une fréquence de $^{\pm}$1/4 de la fréquence d'échantillonnage d'entrée fA = l/T pour donner:

$$\underline{h}(l) = h(l) . e^{j(\pm 2\pi l f A/4 f A) + \phi 0)} = j^{\pm l} . e^{j\phi 0} . h(l)$$

   et par le fait que la phase zéro $\phi$0 de cette porteuse complexe vaut des multiples entiers m de $\pi$/2 ($\phi$0 = m . $\pi$/2 avec m = 0, 1, 2, 3, ...).

3. Filtre demi-bande non récursif selon la revendication 1, caractérisé
   par le fait que l'on forme chaque fois des signaux de différence à partir du signal de sortie du dernier élément de temporisation moins le signal d'entrée du premier élément de temporisation, ce qui donne le premier signal de différence, à partir du signal de sortie du pénultième élément de temporisation moins le signal d'entrée du second élément de temporisation ce qui donne le second signal de différence, à partir du signal de sortie de l'antépénultième élément de temporisation moins le signal d'entrée du troisième élément de temporisation, ce qui donne le troisième signal de différence, etc.,
   par le fait que l'on soumet ces signaux de différence à une valorisation (multiplication) par une valeur h(l) de la réponse impulsionnelle et qu'ensuite on les additionne, ce qui donne soit la partie réelle, soit la partie imaginaire du signal de sortie du filtre $\underline{s}$(2kT),
   par le fait que dans une seconde branche est prévu un élément de temporisation d'une durée de temporisation T.(N - 3)/2 dans lequel on envoie une sur deux valeur d'échantillonnage, décalée par rapport aux valeurs d'échantillonnage ci-dessus, du signal d'entrée et dont le signal de sortie, valorisé par la valeur h(0), donne la partie imaginaire ou la partie réelle du signal de sortie du filtre $\underline{s}$(2kT).

7

**4.** Filtre demi-bande non récursif selon la revendication 3 avec N = 11 et m = 1, caractérisé

par le fait que l'on valorise le premier signal de différence par -h(5), le second signal de différence, par h(3), et le troisième par -h(1) et par le fait que h(0) = 1/2, et

par le fait que la somme des signaux de différence donne la partie réelle $s_r$(2kT) et que le signal valorisé par h(0) donne la partie imaginaire $s_i$(2kT) (figure 4).

**5.** Filtre demi-bande non récursif selon la revendication 3, avec N = 11 et m = 3, caractérisé,

par le fait que la valorisation du premier signal de différence se fait avec h(5), celle du second, avec -h(3), celle du troisième, avec h(1), par le fait que h(0) = -1/2 et par le fait que la somme des signaux de différence donne la partie réelle $s_r$(2kT) et que le signal valorisé avec h(0) donne la partie imaginaire $s_i$(2kT) (figure 4).

**6.** Filtre demi-bande non récursif selon la revendication 3 avec N = 11 et m = 0, caractérisé,

par le fait que la valorisation du premier signal de différence se fait avec h(5), celle du second, avec -h(3) et celle du troisième avec h(1), et

par le fait que la somme des signaux de différence donne la partie imaginaire $s_i$(2kT) et que le signal valorisé avec h(0) = 1/2 donne la partie réelle $S_r$(2kT) (figure 3).

**7.** Filtre demi-bande non récursif selon la revendication 3 avec N = 11 et m = 2, caractérisé,

par le fait que la valorisation du premier signal de différence se fait avec -h(5), celle du second, avec h(3) et celle du troisième avec -h(1), et

par le fait que la somme des signaux de différence donne la partie imaginaire $s_i$(2kT) et que le signal valorisé avec h(0) = 1/2 donne la partie réelle $s_r$(2kT) (figure 3).

**8.** Filtre demi-bande non récursif selon la revendication 2, caractérisé par le fait qu'il est prévu une chaîne (N-1)/2 d'éléments de temporisation d'une durée de temporisation 2T,

par le fait que l'on amène au premier élément de temporisation de cette chaîne la partie réelle $s_r$-(2kT), valorisée avec une valeur h(I) de la réponse impulsionnelle et qu'on la soustrait du signal de sortie du dernier élément de temporisation de cette chaîne, signal de différence qui fournit une sur deux des valeurs d'échantillonnage du signal de sortie réel du filtre s(kT),

par le fait qu'au signal transversal de cette chaîne d'éléments de temporisation, en d'autres points, on ajoute des valeurs instantanées, supplémentaires, valorisées avec une valeur h(I) de la réponse impulsionnelle, de la partie réelle $s_r$(2kT) du signal d'entrée du filtre,

par le fait qu'est prévu un autre élément de temporisation d'une durée de temporisation T.(N-3)/2 à l'entrée duquel on entre la partie imaginaire $s_i$(2kT), valorisée avec h(0) et dont la sortie fournit une sur deux, décalée dans le temps, des valeurs d'échantillonnage du signal de sortie réel du filtre s(kT).

**9.** Filtre demi-bande non récursif selon la revendication 8, avec m = 0 et N = 11, caractérisé par le fait que la valorisation des valeurs instantanées, amenées, de la partie réelle $s_r$(2kT) du signal d'entrée du filtre se fait comme suit:

à l'entrée du premier élément de temporisation, h(5),

à l'entrée du second élément de temporisation, -h(3),

à l'entrée du troisième élément de temporisation, h(1),

à l'entrée du quatrième élément de temporisation, -h(1),

à l'entrée du cinquième élément de temporisation, h(3), et

à la sortie du cinquième élément de temporisation, -h(5), et

par le fait que h(0) = 1/2 (figure 6).

FIG. 2

FIG. 1

FIG. 5

FIG. 3

(m=0;2 ; N=11)

$m=1$ und $m=3$ für $N=11$

$\downarrow$ 2 Verminderung

$s\ (kT)$

$f_A$

$\mp h(5)$  $\pm h(3)$  $\mp h(1)$

$s_r\ (2kT)$

$s_i\ (2kT)$  $\underline{s}\ (2kT)$

$h(o) = \pm\dfrac{1}{2}$

FIG. 4

$(m=1;3;\ N=11)$

FIG. 6 (m=0;2; N=11)

FIG. 7

( m = 1;3 ;  N=11 )